# EUROPEAN PATENT SPECIFICATION

(11) **EP 0 926 598 B1**
(45) Date of publication and mention of the grant of the patent: **16.10.2002**
(21) Application number: 97122571.9
(22) Date of filing: 19.12.1997
(51) Int. Cl.: G06F 11/26, G01R 31/3185

(54) **A field programmable gate array with integrated debugging facilities**
Benutzerprogrammierbares Gatterfeld mit integrierten Fehlersuchsystemen
Circuit prédiffusé programmable doté d'un système intégré de débogage

(43) Date of publication of application: 30.06.1999
(60) Divisional application: 01101374.5
(73) Proprietor: Mentor Graphics Corporation, Wilsonville, Oregon (US)
(72) Inventor: Barbier, Jean, 92320 Chatillon (FR); Lepape, Olivier, 75016 Paris (FR); Reblewski, Frédéric, 91470 Les Molières (FR)
(74) Representative: Patentanwälte Leinweber & Zimmermann

(56) References cited:
- US-A- 5 321 828
- US-A- 5 425 036
- US-A- 5 680 583

## Description

### BACKGROUND OF THE INVENTION

### 1. Field of the Invention

The present invention relates to the fields of field programmable gate array (FPGA) and emulation systems.

### 2. Background Information

Emulation systems for emulating circuit design are known in the art. Typically, prior art emulation systems are formed using general purpose FPGAs without integrated debugging facilities. A circuit design to be emulated is "realized" on the emulation system by compiling a "formal" description of the circuit design, and mapping the circuit design onto the logic elements (LEs) of the FPGAs.

These general purpose FPGAs, as far as their applications to emulation systems are concerned, have a number of disadvantages. First of all, the states of signals at the nodes mapped inside the FPGAs are not directly observable, thus the term "hidden" nodes. Secondly, in order to be able to observe the states of signals at these "hidden" nodes, reconfiguration, and therefore extremely time consuming recompilation is required to bring these signals outside the FPGAs to a logic analyzer. Thirdly, a number of the FPGA I/Os will have to be consumed for bringing these signals to the logic analyzer. Furthermore, the additional signals to be routed further increase signal routing congestion. Finally, for timing sensitive applications, it is difficult to know whether the signals at these "hidden" nodes were read at precisely the correct time or not, if the signals are to be read in response to the occurrence of certain events, since the signals have to be brought out of the FPGAs before the read triggering events can be detected.

US-A-5 425 036 describes an emulation system using FPGAs wherein the logic elements of the FPGAs incorporate a D flip-flop which may be utilized to hold the output signal of the logic element on demand. The FPGAs are additionally provided with boundary scan test logic incorporating built-in self-test which complies with all the relevant specifications given in the IEEE Standard 1149.1 (PROC. FIFTH GREAT LAKES SYMPOSIUM ON VLSI, 16-18 March 1995, pages 242-246, IEEE Computer Society Press, Los Alamitos, CA, US; POTTINGER, H. J. et al.: "Using a reconfigurable field programmable gate array to demonstrate boundary scan with built in self test"). The FPGAs, if specifically configured, enable initialization of the D flip-flops in the LEs. Reconfiguration is, however, necessary after initialization to implement the operational circuit to be emulated. Thus, it is desirable to have an improved FPGA with integrated debugging facilities that is more suitable for usage by the emulation systems in that the need to reconfigure the circuitry from initialization to the operational circuit is eliminated.

This is attained in the present invention as defined in claim 1.

The Improved FPGA according to the present invention comprises a number of enhanced logic elements (LEs) interconnected to each other, preferably, via a network of crossbars. Each enhanced LE comprises a multiple input-single output truth table and a complementary pair of master-slave latches having a data, a set and a reset input, and control logic. As a result, the enhanced LE may be used for "level sensitive" as well as "edge sensitive" circuit design emulations. Each enhanced LE further comprises a plurality of multiplexors and buffers, allowing each LE to be individually initialized, its state to be frozen momentarily, and the frozen state to be read or modified. Additionally, the improved FPGA further comprises a complementary context bus and read/write facilities for setting the enhanced LEs' initial values, and for reading of their frozen states. The improved FPGA also comprises a scan register for outputting trace data for the enhanced LEs. Lastly, the improved FPGA also comprises a plurality of trigger circuitry for conditionally generating a plurality of trigger inputs.

### BRIEF DESCRIPTION OF DRAWINGS

The present invention will be described by way of exemplary embodiments, but not limitations, illustrated in the accompanying drawings in which like references denote similar elements, and in which:
**Figure 1** illustrates the major functional blocks of the FPGA of the present invention;
**Figure 2** illustrates one embodiment of the LE array of **Fig. 1,** and one embodiment of the enhanced LE;
**Figure 3** illustrates one embodiment each of the control logic and input selector for the master-slave latches of **Fig. 1;**
**Figures 4a - 4b** illustrate one embodiment of the inter-LE crossbar network of **Fig. 1**
**Figure 5** illustrates one embodiment of the inter-FPGA crossbar network stage0 of **Fig. 1;**
**Figure 6** illustrates one embodiment of the associated read/write facilities of the context bus of **Fig. 1;**
**Figures 7a - 7b** are two exemplary timing diagrams illustrating the reading of a value from a LE and the writing of a value into a LE;
**Figure 8** illustrates one embodiment of the scan register of **Fig. 1**; and
**Figure 9** illustrates one embodiment of the trigger circuitry of **Fig. 1.**

### DETAILED DESCRIPTION OF THE INVENTION

In the following description, for purposes of explanation, specific numbers, materials and configurations are set forth in order to provide a thorough understanding of the present invention. However, it will be apparent to one skilled in the art that the present invention may be practiced without the specific details. In other instances, well known features are omitted or simplified in order not to obscure the present invention.

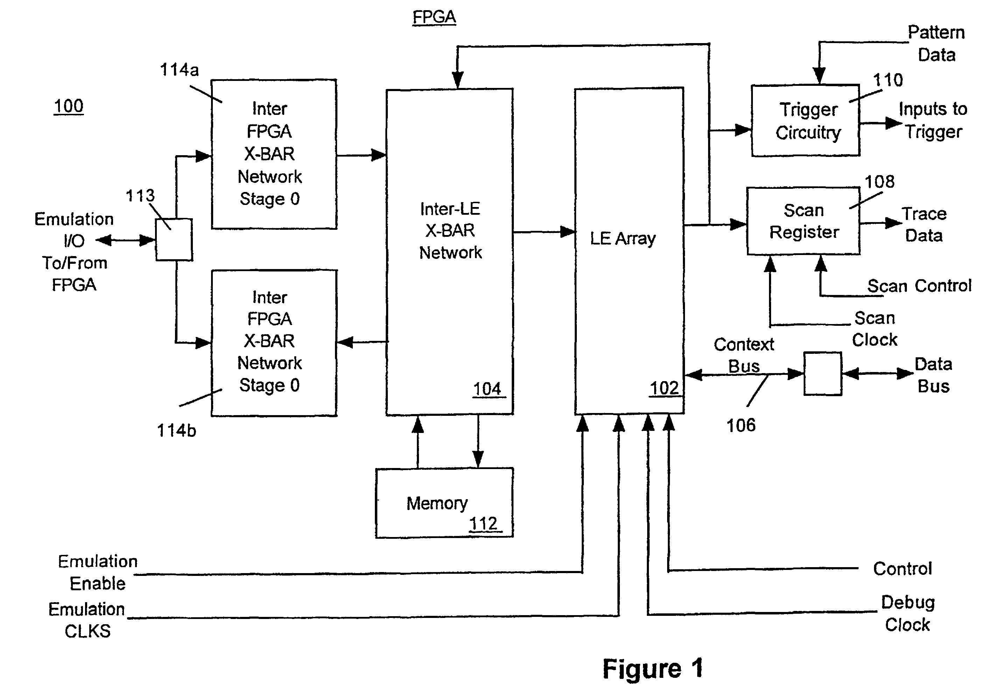

Referring now to **Figure 1,** the major functional blocks of improved FPGA **100** of the present invention are illustrated. As shown, FPGA **100**, which is disposed on a single integrated circuit (or chip), comprises an array **102** of enhanced LEs incorporated with the teachings of the present invention. As in the prior art, the enhanced LEs are used to "realize" various elements of circuit designs, however, as will be disclosed in more detail below, unlike the prior art, the enhanced LEs include new and innovative debugging features.

Additionally, FPGA **100** further advantageously includes on-chip context bus **106,** scan register **108** and trigger circuitry **110,** coupled to the enhanced LEs as shown. As will be disclosed in more detail below, context bus **106** is used for inputting and outputting values to and from the LEs, whereas scan register **108** and trigger circuitry **110** are used to output trace data and trigger inputs for FPGA **100** respectively.

Preferably, FPGA **100** includes memory **112** to facilitate usage of FPGA **100** for emulating circuit designs with memory. In one embodiment, memory **112** is 16-bit wide. Preferably, the pins **113** of FPGA **100** can be used for either input or output. In one embodiment, 64 I/O pins **113** are provided to FPGA **100.** Preferably, FPGA **100** also includes inter-LE crossbar (or x-bar) network **104** for interconnecting the LEs, memory **112,** and I/O pins **113,** as shown. Finally, it is also preferable for FPGA **100** to include "two copies" of the first stage of a crossbar network **114a - 114b** for inter-connecting FPGA **100** to other FPGAs and a "host system".

Memory **112** is well known in the art and will not be further described. Inter-LE crossbar network **104** and the first stage of inter-FPGA crossbar network **114a** will be briefly described below. LEs, context bus **106,** scan register **108,** and trigger circuitry **110** will be described in further detail below with additional references to the remaining figures.

Before describing these elements in further detail, it should be noted that while for ease of explanation, the present invention is being described in the context of emulation, however, based on the description to follow, a person skilled in the art will appreciate that the present invention may be adapted for other applications beside emulation systems.

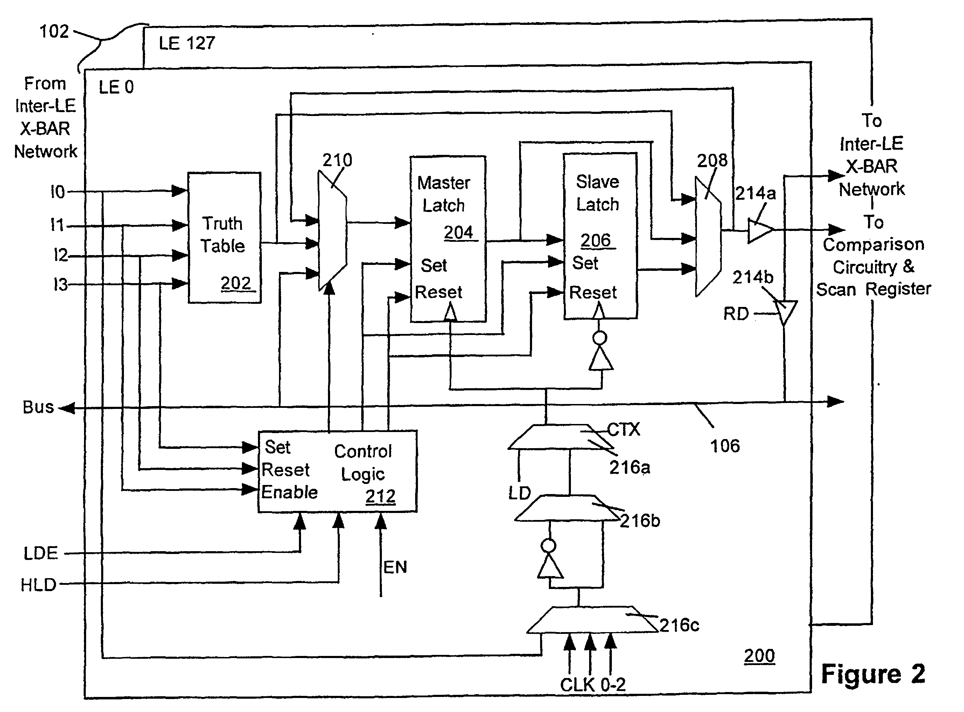

**Figure 2** illustrates one embodiment of the array of enhanced LEs of **Fig.1** and one embodiment of the LEs themselves in further detail. As shown, LE array **102** comprises a plurality of enhanced LEs **200** of the present invention. In one embodiment, LE array **102** comprises 128 LEs **200.** Each LE **200** includes a multiple input - single output truth table **202,** a pair of master-slave latches **204- 206,** output multiplexor **208,** input multiplexor **210,** and control logic **212,** coupled to each other as shown.

Truth table **202** is used to generate a predetermined output in response to a set of inputs. For the illustrated embodiment, truth-table **202** has 4 inputs and 1 output. In other words, depending on the inputs, truth table **202** outputs 1 of 2⁴ of predetermined outputs. Each of master-slave latches **204 - 206** is used to store an input value synchronously with its clock input. Furthermore, each of master-slave latches **204 - 206** can be asynchronously forced to one or zero depending on the values of set and reset. For the illustrated embodiment, the set and reset inputs are provided using the inputs I3 and I2 of truth table **202.** In other words, if set/reset is used, the number of input variations that can be provided to truth-table **202** are reduced. Alternatively, additional dedicated pins may be provided to provide the set/reset signals to master-slave latches **204 - 206,** however the real estate requirement of the FPGA will be increased.

Output multiplexor **208,** input multiplexor **210** and control logic **212** are used to control the manner in which truth table **202** and master-slave latches **204 - 206** are used. Output multiplexor **208** allows either the output of truth table **202** (bypassing master-slave latches **204 - 206)** or the output of slave latch **206** (for level sensitive designs), or the output of master latch **204** (for edge sensitive designs) to be selected for output. The by-passed output is selected if truth table **202** is to be used standalone. When either the output of master or slave latch **204** or **206** is selected, input multiplexor **210** allows either the output of truth table **202,** the feedback from output multiplexor **208,** or an input value on context bus **106** to be provided to master-slave latches **204 - 206.** The feedback value is selected to "freeze" LE **200,** and the bus value is selected to initialize LE **200**. Control logic **212** controls input multiplexor **210** and the set and reset values provided to master-slave latches **204 - 206,** in accordance to a set, a reset, a first and a second enable (ENAB and EN), a load (LDE) and a hold (HLD) value provided, to be described more fully below.

Each LE **200** also includes clock selection multiplexors **216a - 216c** for selectively providing a number of emulation clocks or a debug clock (LD) to master-slave latches **204 - 206.** Preferably, the emulation clocks include a "constructed" emulation clock using other LEs **200.** For the illustrated embodiment, this "constructed" emulation clock is made available through I0 of truth table **202.** One of the emulation clocks is provided to master-slave latches **204 - 206** during normal operation, whereas the debug clock (LD) is provided during debugging. The clock selection is controlled by the CTX signal. Lastly, LE **200** also includes buffer **214a** for outputting the selected output to inter-LE X-bar network **104** and the on-chip debugging facilities, and buffer **214b** for outputting the selected output onto context bus **106** for direct observation outside FPGA **100.**

In sum, truth table **202** may be used in a standalone manner, or in conjunction with the corresponding master-slave latches **204 - 206.** Enhanced LE **200** is suitable for "level sensitive" as well as "edge sensitive" circuit design emulations. Additionally, beside the "normal" current output of truth table **202,** each LE **200** can be individually initialized. Each LE **200** can also be caused to output the same output over and over again, as if it is frozen. Furthermore, LEs **200** are individually and directly observable outside FPGA **100.** In other words, there are no "hidden nodes". The state of each "node" is directly observable outside the FPGA, without requiring the reconfiguration and time consuming re-compilation of circuit design mappings normally performed under the prior art.

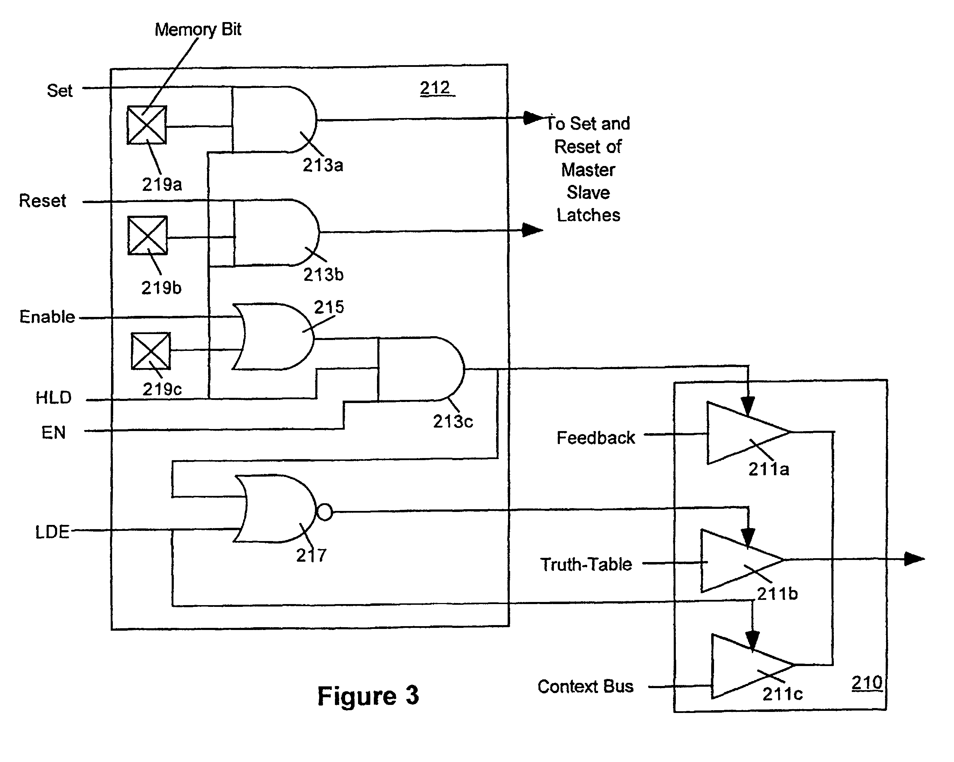

**Figure 3** illustrates one embodiment each of input multiplexor **210** and control logic **212** in further detail. As shown, multiplexor **210** comprises drivers **211a** - **211c** for outputting the feedback output, the output of truth-table **202,** and the input value on context bus **106** respectively, if enabled. One of drivers **211a - 211c** is selectively enabled by control signals from control logic **212**. Control logic **212** comprises AND gates **213a - 213c,** OR gate **215,** NOR gate **217,** and memory bits **219a - 219c** for generating the control signals for driver **211a - 211c,** as well as the set and reset values for master-slave latches **204 - 206.** Memory bits **219a - 219c** are used to store configuration information for enabling the provision of the set and reset values and the selection of the feedback output. If enabled, AND gates **213a - 213b** provides the set and reset values in accordance to the set and HLD inputs, and the reset and HLD inputs respectively. If enabled, OR gate **215** in conjunction with AND gate **213c** provide the control signal for driver **211a** in accordance to the ENAB, HLD and EN inputs. NOR gate **217** provide the control signal for driver **211b** in accordance to the control signal being provided for driver **211a** and a LDE input. Lastly, the LDE input is provided as the control signal for driver **211c.**

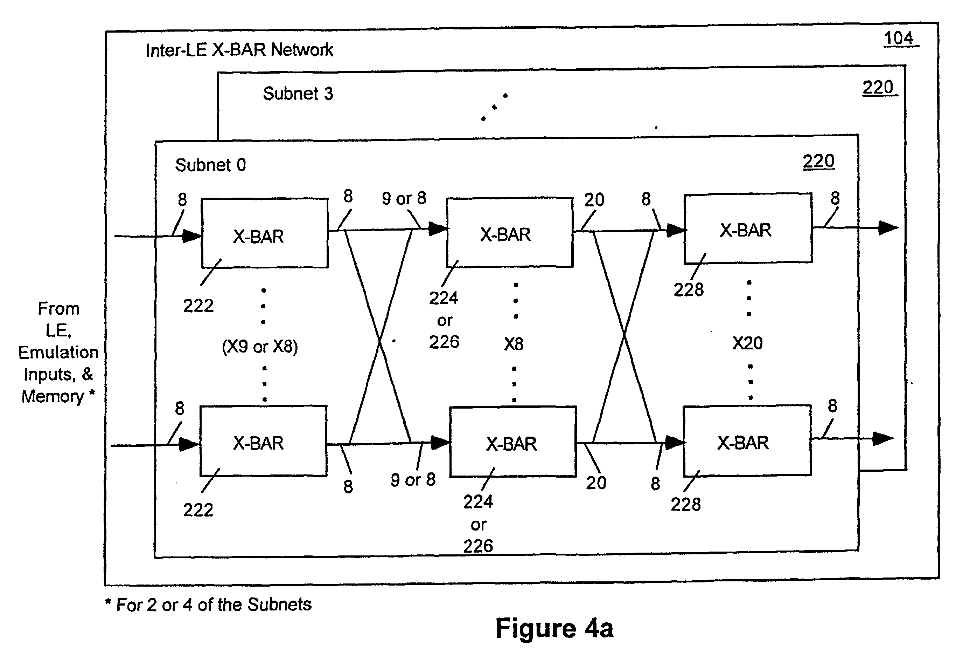

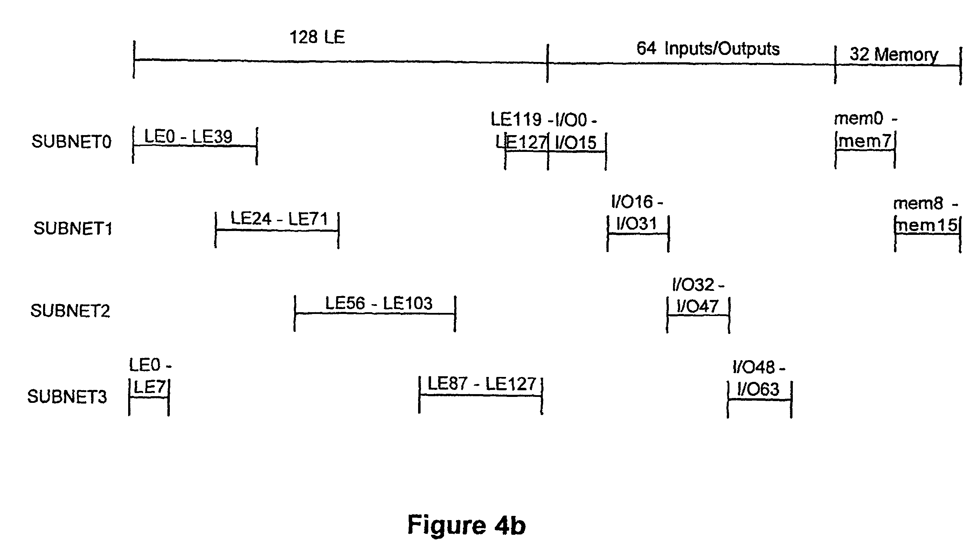

Referring now briefly to **Figures 4a - 4b,** wherein one embodiment of inter-LE crossbar network **104** for interconnecting the LEs, the memory and the I/O pins is illustrated. As shown in **Fig. 4a,** for the illustrated embodiment, inter-LE crossbar network **104** comprises 4 subnetworks **220.** The first two subnetworks, subnet0 and subnet1, are used to route 72 signals, whereas the remaining two subnetworks, subnet2 and subnet3, are used to route 64 signals. More specifically, as shown in **Fig. 4b,** Subnet0 is used to route the signals of LE0 - LE39, LE119 - LE127, I/O0 - I/O15 and M0 - M7. Subnet1 is used to route the signals of LE24 - LE71, I/O16 - I/O31 and M8 - M15. Subnet2 is used to route the signals of LE56 - LE103, and I/O32 - I/O47. Subnet3 is used to route the signals of LE0 - LE7, LE88 - LE127, and I/O48 - I/O63. The overlapping coverage of the LEs provides increased flexibility of signal routing for mapping circuit designs.

Each subnetwork **220** is a three-stage Claus network comprising either 9 or 8 8-to-8 crossbars **222** in the first stage, 8 9-to-20 or 8-to-20 crossbars **224** or **226** in stage two, and 20 8-to-8 crossbars **228** in stage three. The stages are coupled to each other in the well known "butterfly" manner.

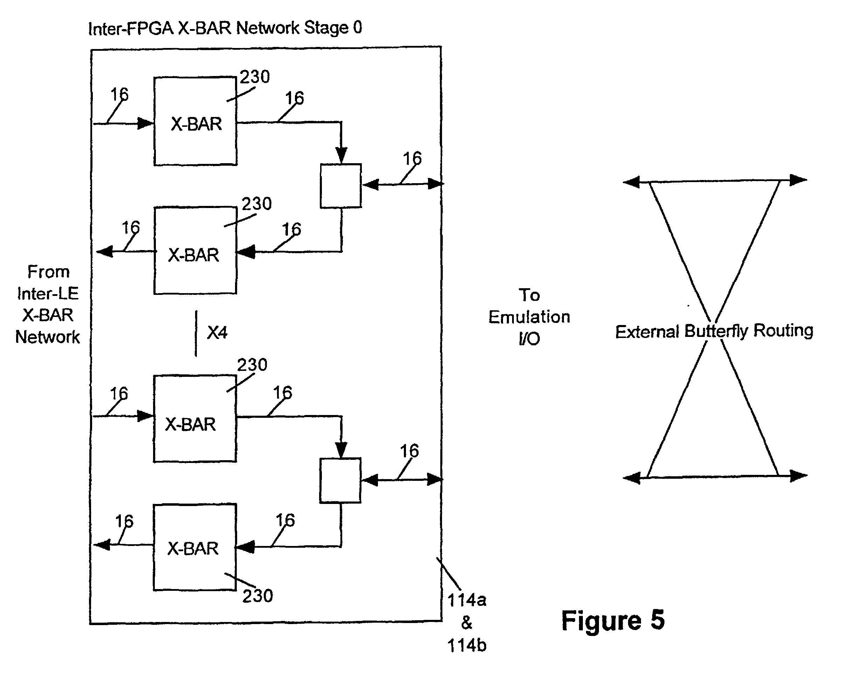

Referring now also briefly to **Figure 5,** wherein one embodiment of inter-FPGA crossbar network stage0 **114a** - **114b** for interconnecting the FPGA to other FPGAs and a "host" computer is illustrated. As shown, for the illustrated embodiment, inter-FPGA crossbar network stage0 **114a - 114b** comprises 4 pairs of 16-to-16 crossbars **230** for coupling 64 I/O signals of the FPGA to the next stage of a Claus network for interconnecting the FPGA to other FPGAs and a "host" computer.

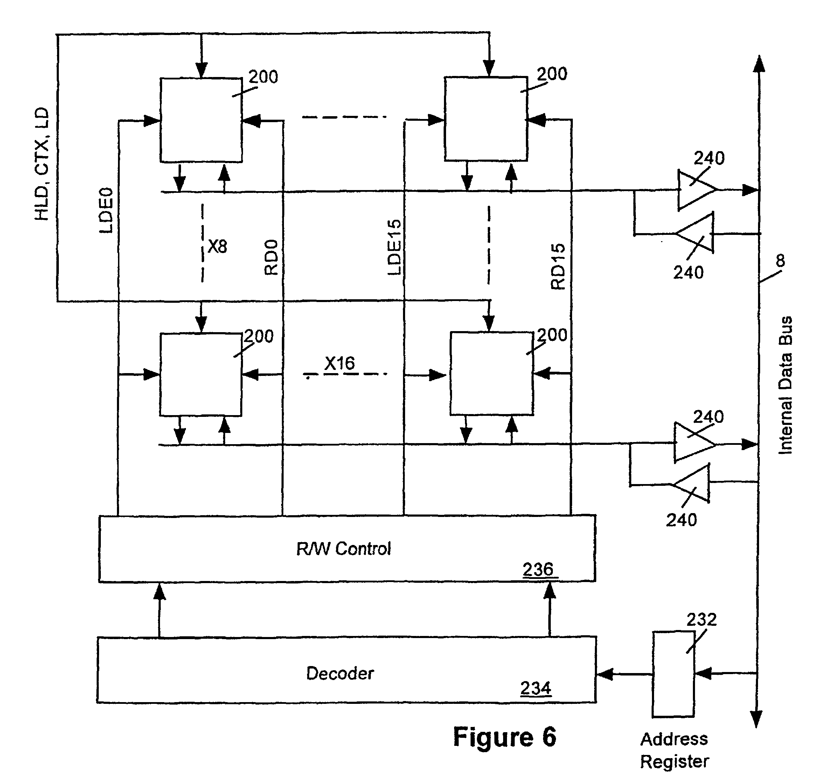

**Figure 6** illustrates one embodiment of the read/write facilities associated with context bus **106** for reading from and writing into LEs **200** of FPGA **100.** As shown, for the illustrated embodiment, 128 LEs **200** are organized in 16 columns, with each column having 8 LEs **200.** Thus, all 128 LEs **200,** or the current context, can be read or written with 16 8-bit words. Address register **232** is provided for storing the read or write address. Decoder **234** is provided for decoding the read or write address, which in conjunction with R/W control **236** provide the appropriate read control signals (RD0 - RD15) and write control signals (LDE0 - LDE15) for the 128 LEs **200.** Additionally, each LE **200** receives the earlier described HLD signal for "freezing" the LEs **200,** the CTX signal for selecting the debug (LD) clock, and the LD clock itself.

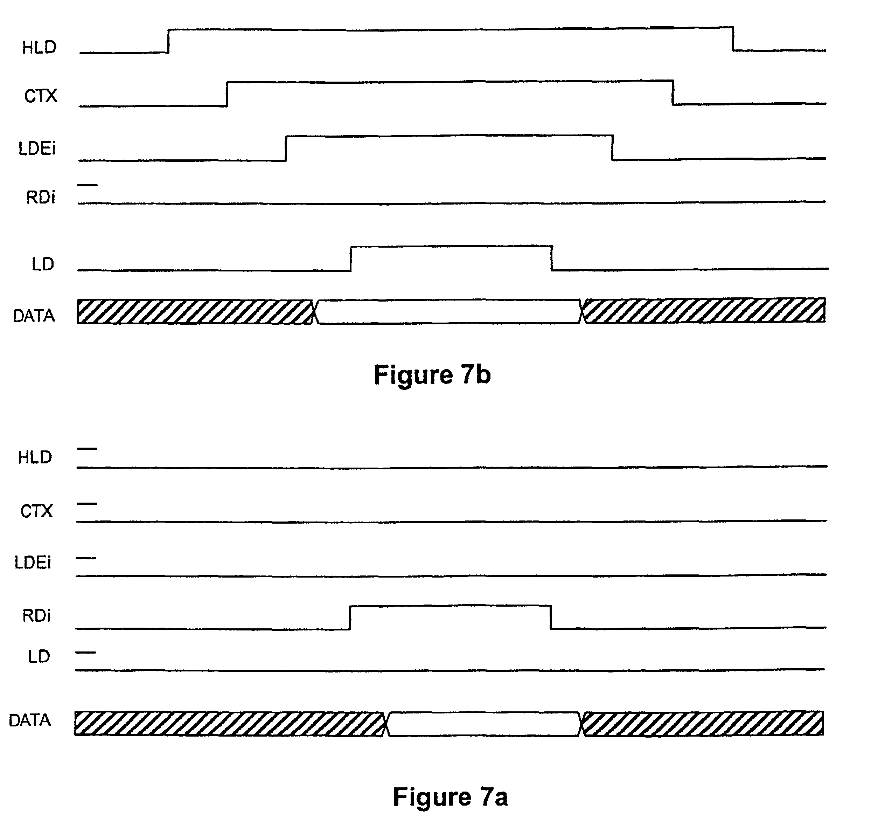

**Figures 7a - 7b** illustrate exemplary signal timings for reading and writing. As shown in **Fig. 7a,** context reading is done by first loading a 4-bit address into address register **232.** As a result, decoder **234** causes R/W control **236** to drive the appropriate RD signals high to read out the contents of the addressed LEs **200.** (HLD, CTX, LDEi and LD all remain low while a read operation is in progress.) As shown in **Fig. 7b,** context writing is done by first loading a 4-bit address into address register **232.** Additionally, before decoder **234** responds and causes R/W control **236** to drive the appropriate LDE signals high, HLD is first driven high to freeze all LEs **200.** Furthermore, CTX is driven high to select debug clock LD for each LE **200.** Then, when R/W control **236** drives the appropriate LDE signals, values on context bus **106** are loaded into the addressed LEs **200.** It is important to freeze all LEs **200** during a context writing, because partial context could induce temporary states, which could in turn put an emulation system into an unknown state. For example, the final context may drive a given RESET signal to the low state, but the partial context (during the writing operation) may induce a temporary high state on the RESET signal, thus unpredictably resetting all the latches connected to the signal.

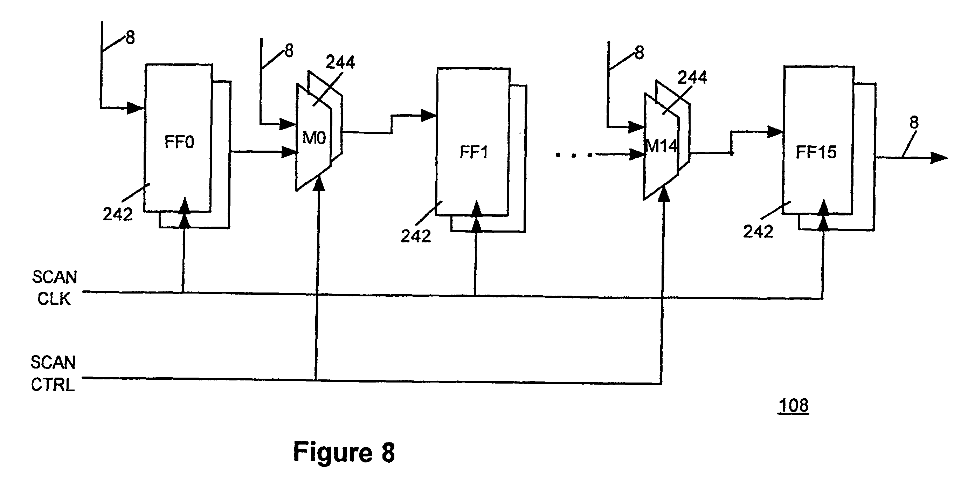

**Figure 8** illustrates one embodiment of scan register **108** for outputting trace data. As shown, for the illustrated embodiment, scan register **108** comprises 16 sets of 8 flip-flops **242,** and 15 sets of 8 multiplexors **244,** disposed in between flip-flop sets **242.** Flip-flop set0 **242** is coupled to a first group of 8 LEs **200.** Multiplexor set0 **244** is coupled to flip-flop set0 **242** and a second group of LEs **200.** Flip-flop set1 **242** is coupled to multiplexor set0, and so forth. Flip-flop set0 **242** sequentially receives and propagates the outputs of the first group of 8 LEs **200.** Multiplexor set0 **242** either serially provides the outputs of flip-flop set0 **242** or the outputs of the second group of 8 LEs. Flip-flop set1 **242** in turn sequentially propagates the inputs it received from multiplexor set0 **244.** Flip-flop sets **242** are controlled by a scan clock, whereas, multiplexor sets **244** are controlled by a scan control signal. Thus, by applying a scan clock having the appropriate divided frequency (relative to the operating emulation clock), and selectively applying the appropriate scan control signal to the multiplexor sets **244,** a snapshot of 128 LEs at a particular clock cycle can be sequentially scanned out of FPGA **100.**

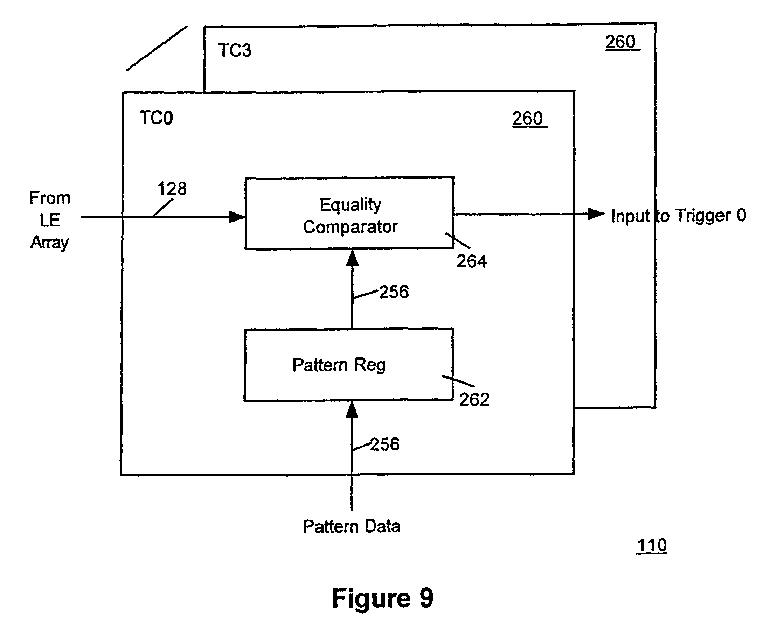

**Figure 9** illustrates one embodiment of trigger circuitry **110** for outputting trigger inputs. As shown, for the illustrated embodiment, trigger circuitry **110** comprises 4 comparator-register circuits **260** for generating 4 trigger inputs, one from each comparator-register circuit **260.** Each comparator-register circuit **260** includes a register **262** for storing a signal pattern, and an equality comparator **264** for comparing the outputs of the LEs to the stored content of pattern register **262.** In one embodiment, the signal pattern comprises 2-bits per LE **200,** allowing the values of High, Low, or Don't Care to be encoded. An input to a trigger outside FPGA **100** is generated whenever the stored pattern is detected. In other words, for the illustrated embodiment, 4 LE internal state events can be monitored simultaneously.

Thus, an improved FPGA with integrated debugging facility that is particularly suitable for emulation systems has been described. While the method and integrated circuit of the present invention has been described in terms of the above illustrated embodiments, those skilled in the art will recognize that the invention is not limited to the embodiments described. The present invention can be practiced with modification and alteration within the scope of the appended claims. The description is thus to be regarded as illustrative instead of restrictive on the present invention.

## Claims

1. A single integrated field programmable gate array circuit comprising
a plurality of reconfigurable logic elements (LEs) (200) for generating a plurality of output signals in response to a plurality of input signals correspondingly applied to the LEs (200), each of the LEs being equipped to hold constant the LE's output signal on demand;
a context bus (106) on said single integrated circuit and coupled to the LEs (200) for outputting individual signal state values of the LEs (200) out of the integrated circuit, and for initializing the LEs (200) with individual signal state values provided to the integrated circuit without reconfiguring the LEs (200) and while the output signals of the LEs (200) are being held constant; and
read/write control circuitry (232, 234, 236) coupled to the LEs (200) and the context bus (106) for controlling said outputting of individual signal state values of the LEs (200) and said initializing of the LEs with individual signal state values.

2. The integrated circuit as set forth in claim 1, wherein the integrated circuit further comprises a scan register (108) coupled to the LEs (200) for serially capturing and outputting a trace record of all signal state values of the LEs in a particular clock cycle of an operating clock outside the integrated circuit, the scan register (108) being provided with a scan clock appropriately scaled to the operating clock.

3. The integrated circuit as set forth in anyone of claims 1 or 2, wherein the integrated circuit further comprises trigger circuitry (110) coupled to the LEs (200) for conditionally generating at least one trigger value depending on a comparison between a stored signal pattern and the signal state values of the LEs (200).

4. The integrated circuit as set forth in claim 3, wherein the trigger circuitry (110) comprises
a first register (262) for storing a first trigger pattern; and
a first comparator (264) coupled to the LEs (200) and the first register (262) for conditionally generating a first trigger value if signal state values of the LEs (200) match the stored first trigger pattern.

5. The integrated circuit as set forth in anyone of claims 1 to 4, wherein
each LE (200) further includes a multiple input-single output truth table (202) for generating a first intermediate output signal in response to a first set of input signals; a first selector (210) coupled to the truth table (202) and the context bus (106) for selecting either the first intermediate output signal, the output of the LE fed back to the first selector (210), or a predesignated bus signal on the context bus (106), and outputting the selected signal; and
a first control circuit (212) coupled to the first selector (210) for controlling the first selector.

6. The integrated circuit as set forth in claim 5, wherein each LE (200) further comprises
a pair of master-slave latches (204, 206), each having a data input, a set input, and a reset input, coupled to the first selector (210) for generating a second and a third intermediate output signal in response to the data, set, and reset inputs, the selected and third intermediate output signals being provided as data inputs to the master and slave latches respectively;
a second control circuit (212) coupled to the pair of master-slave latches (204, 206) for providing each of the master and slave latches with a set and a reset value; and
a second selector (208) coupled to the truth table (202) and the master-slave latches (204, 206) for selecting either the first, second or third intermediate output signal as the output signal of the LE (200).

7. The integrated circuit as set forth in claim 6, wherein each LE (200) further comprises a buffer (214b) coupled to the second selector (208) for outputting the output signal of the LE (200) onto the context bus (106).

8. The integrated circuit as set forth in anyone of claims 6 or 7, wherein the second control circuit (212) comprises a first and a second AND gate (213a, b) for receiving a first and a second plurality of input control signals, and in response, generating the set and reset values for the master and slave latches (204, 206) respectively.

9. The integrated circuit as set forth in anyone of claims 6 to 8, wherein the LE (200) further comprises a third selector (216a) for selectively providing either an emulation clock or a debugging clock to the master and slave latches (204, 206).

10. The integrated circuit as set forth in claim 9, wherein the LE (200) further comprises a fourth and a fifth selector (216b, c) for selectively providing one of a plurality of clocks to the third selector (216a) as the emulation clock.

11. The integrated circuit as set forth In anyone of claims 5 to 10, wherein the first control circuit (212) comprises an OR gate (215) and an AND gate (213c) serially coupled to the OR gate (215) for receiving a plurality of input control signals, and in response, generating an output control signal for causing the first selector (210) to select the output signal of the LE fed back to the first selector (210).

12. The integrated circuit as set forth In anyone of claims 5 to 11, wherein the first control circuit (212) comprises a NOR gate (217) for receiving a plurality of input control signals, and in response, generating an output control signal for causing the first selector (210) to select the first intermediate output signal.

13. The integrated circuit as set forth in anyone of claims 5 to 12, wherein the control circuit (212) receives a load control signal, and in response, outputs the load control signal for the first selector (210) for causing the first selector to select the predesignated bus signal on the context bus (106).

## Patentansprüche

1. Integrierter benutzerprogrammierbarer Gatterfeldschaltkreis mit
einer Anzahl rekonfigurierbarer logischer Elemente (LEs) (200) zur Erzeugung einer Anzahl von Ausgangssignalen ansprechend auf eine Anzahl von an die LEs (200) entsprechend angelegter Eingangssignale, wobei jedes der LEs dafür ausgerüstet ist, das Ausgangssignal des LE auf Anforderung konstant zu halten;
einem auf dem integrierten Schaltkreis vorgesehenen und an die LEs (200) gekoppelten Kontextbus (106) zum Ausgeben individueller Signalzustandswerte der LEs (200) aus dem integrierten Schaltkreis und zum Initialisieren der LEs mit dem integrierten Schaltkreis zugeführten individuellen Signalzustandswerten, ohne die LEs (200) zu rekonfigurieren und unter Konstanthaltung der Ausgangssignale der LEs (200); und
einer an die LEs (200) und den Kontextbus (106) gekoppelten Lese/Schreibsteuerschaltung (232, 234, 236) zur Steuerung des Ausgebens individueller Signalzustandswerte der LEs (200) und des Initialisierens der LEs mit individuellen Signalzustandswerten.

2. Integrierter Schaltkreis nach Anspruch 1, wobei der integrierte Schaltkreis ein an die LEs (200) gekoppeltes Abtastregister (108) zum seriellen Erfassen und Ausgeben einer Nachverfolgungsaufzeichnung aller Signalzustandswerte der LEs in einem einzelnen Taktzyklus eines Arbeitstakts aus dem integrierten Schaltkreis heraus aufweist, wobei das Abtastregister (108) mit einem zu dem Arbeitstakt passend skalierten Abtasttakt versehen ist.

3. Integrierter Schaltkreis nach einem der Ansprüche 1 oder 2, wobei der integrierte Schaltkreis ferner eine an die LEs (200) gekoppelte Triggerschaltung (110) zur bedingungsabhängigen Erzeugung mindestens eines Triggerwertes in Abhängigkeit von einem Vergleich zwischen einem gespeicherten Signalmuster und den Signalzustandswerten der LEs (200) aufweist.

4. Integrierter Schaltkreis nach Anspruch 3, wobei die Triggerschaltung (110) aufweist
ein erstes Register (262) zur Speicherung eines ersten Triggermusters; und
einen an die LEs (200) und das erste Register (262) gekoppelten ersten Vergleicher (264) zur bedingungsabhängigen Erzeugung eines ersten Triggerwertes, wenn die Signalzustandswerte der LEs (200) zu dem gespeicherten ersten Triggermuster passen.

5. Integrierter Schaltkreis nach einem der Ansprüche 1 bis 4, wobei
jedes LE (200) ferner eine Mehrfacheingangs-Einfachausgangs-Wahrheitstabelle (202) zur Erzeugung eines ersten Zwischenausgangssignals ansprechend auf einen ersten Satz von Eingangssignalen aufweist; einen an die Wahrheitstabelle (202) und den Kontextbus (106) gekoppelten ersten Auswähler (210) zum Auswählen entweder des ersten Zwischenausgangssignals, des zu dem ersten Auswähler (210) zurückgeführten Ausgangs des LE oder eines vorbestimmten Bussignals auf dem Kontextbus (106), und zum Ausgeben des ausgewählten Signals; und
einen an den ersten Auswähler (210) gekoppelten ersten Steuerschaltkreis (212) zum Steuern des ersten Auswählers.

6. Integrierter Schaltkreis nach Anspruch 5, wobei jedes LE (200) ferner aufweist
ein an den ersten Auswähler (210) gekoppeltes Paar von Master-Slave-Halteschaltungen (204, 206), deren jede einen Dateneingang, einen Setzeingang und einen Rücksetzeingang aufweist, zur Erzeugung eines zweiten und dritten Zwischenausgangssignals ansprechend auf die Daten-, Setz- und Rücksetzeingänge, wobei das ausgewählte und das dritte Zwischenausgangssignal als Dateneingänge zu der Master- bzw. Slave-Halteschaltung vorgesehen sind;
einen an das Paar von Master-Slave-Halteschaltungen (204, 206) gekoppelten zweiten Steuerschaltkreis (212) zur Belieferung jeder der Master- und Slave-Halteschaltungen mit einem Setz- und einem.Rücksetzwert; und
einen an die Wahrheitstabelle (202) und die Master-Slave-Halteschaltung (204, 206) gekoppelten zweiten Auswähler (208) zum Auswählen entweder des ersten, zweiten oder dritten Zwischenausgangssignals als das Ausgangssignal des LE (200).

7. Integrierter Schaltkreis nach Anspruch 6, wobei jedes LE (200) ferner einen an den zweiten Auswähler (208) gekoppelten Puffer (214b) zum Ausgeben des Ausgangssignals des LE (200) auf den Kontextbus (106) aufweist.

8. Integrierter Schaltkreis nach einem der Ansprüche 6 oder 7, wobei der zweite Steuerschaltkreis (212) ein erstes und ein zweites UND-Verknüpfungsglied (213a, b) zum Empfangen einer ersten und einer zweiten Anzahl von Eingangssteuersignalen aufweist und zum darauf ansprechenden Erzeugen der Setz- und Rücksetzwerte für die Master- bzw. Slave-Halteschaltung (204, 206).

9. Integrierter Schaltkreis nach einem der Ansprüche 6 bis 8, wobei das LE (200) ferner einen dritten Auswähler (216a) zur wahlweisen Lieferung entweder eines Emulationstaktes oder eines Fehlersuchtaktes an die Master- und Slave-Halteschaltungen (204, 206) aufweist.

10. Integrierter Schaltkreis nach Anspruch 9, wobei das LE (200) ferner einen vierten und einen fünften Auswähler (216b, c) zur selektiven Lieferung eines aus einer Anzahl von Takten an den dritten Auswähler (216a) als den Emulationstakt.

11. Integrierter Schaltkreis nach einem der Ansprüche 5 bis 10, wobei der erste Steuerschaltkreis (212) ein ODER-Verknüpfungsglied (215) und ein an das ODER-Verknüpfungsglied (215) seriell gekoppeltes UND-Verknüpfungsglied (213c) zum Empfangen einer Anzahl von Eingangssteuersignalen aufweist und zum darauf ansprechenden Erzeugen eines Ausgangssteuersignals, durch das der erste Auswähler (210) dazu veranlaßt wird, das an den ersten Auswähler (210) zurückgeführte Ausgangssignal des LE auszuwählen.

12. Integrierter Schaltkreis nach einem der Ansprüche 5 bis 11, wobei der erste Steuerschaltkreis (212) ein NICHT-ODER-Verknüpfungsglied (217) zum Empfangen einer Anzahl von Eingangssteuersignalen aufweist und zum darauf ansprechenden Erzeugen eines Ausgangssteuersignals, durch das der erste Auswähler (210) dazu veranlaßt wird, das erste Zwischenausgangssignal auszuwählen.

13. Integrierter Schaltkreis nach einem der Ansprüche 5 bis 12, wobei der Steuerschaltkreis (212) ein Ladesteuersignal empfängt und darauf ansprechend das Ladesteuersignal für den ersten Auswähler (210) ausgibt, durch das der erste Auswähler dazu veranlaßt wird, das vorbestimmte Bussignal auf dem Kontextbus (106) auszuwählen.

## Revendications

1. Circuit à matrice prédiffusée programmable unique à champ intégré comprenant
plusieurs éléments logiques reprogrammables (LEs)(200) pour produire une pluralité de signaux de sortie en réponse à une pluralité de signaux d'entrée appliqués d'une manière correspondante aux LEs (200), chacun des LEs étant équipé pour maintenir constant le signal de sortie du LEs sur demande;
un bus de contexte (106) sur ledit circuit intégré unique et couplé aux LEs (200) pour émettre des valeurs d'état de signaux individuels des LEs (200) du circuit intégré, et pour initialiser les LEs (200) avec des valeurs d'état de signaux individuels fournies au circuit intégré sans reprogrammer les LEs (200) et pendant que les signaux de sortie des LEs (200) sont maintenus constants; et
des circuits de commande de lecture/écriture (232, 234, 236) couplés aux LEs (200) et au bus de contexte (106) pour commander ladite émission de valeurs d'état de signaux individuels des LEs (200) et ladite initialisation des LEs avec des valeurs d'état de signaux individuels.

2. Circuit intégré selon la revendication 1, où le circuit intégré comprend en outre un registre de balayage (108) couplé aux LEs (200) pour capturer et émettre en série un enregistrement de trace de toutes les valeurs d'état des signaux des LEs pendant un cycle d'horloge particulier d'une horloge de fonctionnement à l'extérieur du circuit intégré, le registre de balayage (108) présentant une horloge de balayage mise à l'échelle d'une manière appropriée à l'horloge de fonctionnement.

3. Circuit intégré selon l'une des revendications 1 ou 2, où le circuit intégré comprend en outre des circuits de déclenchement (110) couplés aux LEs (200) pour générer conditionnellement au moins une valeur de déclenchement en fonction d'une comparaison entre un modèle de signal stocké et les valeurs d'état des signaux des LEs (200).

4. Circuit intégré selon la revendication 3, où les circuits de déclenchement (110) comprennent:
un premier registre (262) pour stocker un premier modèle de déclenchement; et
un premier comparateur (264) couplé aux LEs (200) et au premier registre (262) pour générer conditionnellement une première valeur de déclenchement dans le cas où les valeurs d'état des signaux des LEs (200) correspondent au premier modèle de déclenchement stocké.

5. Circuit intégré selon l'une des revendications 1 à 4, dans lequel
chaque LE (200) comporte en outre une table logique (202) à entrées multiples et à sortie unique pour produire un premier signal de sortie intermédiaire en réponse à un premier ensemble de signaux d'entrée;
un premier sélecteur (210) couplé à la table logique (202) et au bus de contexte (106) pour sélectionner l'un parmi le premier signal de sortie intermédiaire, la sortie du LE réinjectée dans le premier sélecteur (210) ou un signal de bus pré-désigné sur le bus de contexte (106), et pour émettre le signal sélectionné; et
un premier circuit de commande (212) couplé au premier sélecteur (210) pour commander le premier sélecteur.

6. Circuit intégré selon la revendication 5, où chaque LE (200) comprend en outre
une paire de circuits à verrouillage maître-esclave (204, 206), chacun ayant une entrée de données, une entrée de mise à l'état et une entrée de remise à l'état, couplées au premier sélecteur (210) pour produire un deuxième et un troisième signal de sortie intermédiaire en réponse aux entrées de données, de mise à l'état et de remise à l'état, les deuxième et troisième signaux de sortie intermédiaires étant fournis comme entrées de données aux circuits à verrouillage maître et esclave respectivement;
un deuxième circuit de commande (212) couplé aux deux circuits à verrouillage maître-esclave (204, 206) pour fournir à chacun des circuits à verrouillage maître et esclave une valeur de mise à l'état et de remise à l'état; et
un deuxième sélecteur (208) couplé à la table logique (202) et aux circuits à verrouillage maître-esclave (204, 206) pour sélectionner soit le premier, deuxième ou troisième signal de sortie intermédiaire comme signal de sortie du LE (200).

7. Circuit intégré selon la revendication 6, où chaque LE (200) comprend en outre un tampon (214b) couplé au deuxième sélecteur (208) pour émettre le signal de sortie du LE (200) sur le bus de contexte (106).

8. Circuit intégré selon l'une des revendications 6 ou 7, où le deuxième circuit de commande (212) comprend une première et une deuxième porte ET (213a,b) pour recevoir une première et une deuxième pluralité de signaux de commande d'entrée et, en réponse, pour produire les valeurs de mise à l'état et de remise à l'état pour les circuits à verrouillage maître et esclave (204, 206) respectivement.

9. Circuit intégré selon l'une des revendications 6 à 8, où le LE (200) comprend en outre un troisième sélecteur (216a) pour fournir sélectivement soit une horloge d'émulation, soit une horloge de mise au point aux circuits à verrouillage maître et esclave (204, 206).

10. Circuit intégré selon la revendication 9, où le LE(200) comprend en outre un quatrième et un cinquième sélecteur (216b,c) pour fournir sélectivement l'une d'une pluralité d'horloges au troisième sélecteur (216a) comme horloge d'émulation.

11. Circuit intégré selon l'une des revendications 5 à 10, où le premier circuit de commande (212) comporte une porte OU (215) et une porte ET (213c) couplée en série à la porte OU (215) pour recevoir une pluralité de signaux de commande d'entrée et, en réponse, pour produire un signal de commande de sortie pour amener le premier sélecteur (210) à sélectionner le signal de sortie du LE reinjecté dans le premier sélecteur (210).

12. Circuit intégré selon l'une des revendications 5 à 11, où le premier circuit de commande (212) comprend une porte NI (217) pour recevoir une pluralité de signaux de commande d'entrée et, en réponse, pour produire un signal de commande de sortie pour amener le premier sélecteur (210) à sélectionner le premier signal de sortie intermédiaire.

13. Circuit intégré selon l'une des revendications 5 à 12, où le circuit de commande (212) reçoit un signal de commande de charge et, en réponse, émet le signal de commande de charge pour le premier sélecteur (210) afin d'amener le premier sélecteur à sélectionner le signal de bus prédésigné sur le bus de contexte (106).
